(19) Europäisches Patentamt / European Patent Office / Office européen des brevets

(11) **EP 3 074 549 B1**

(12) **EUROPÄISCHE PATENTSCHRIFT**

(45) Veröffentlichungstag und Bekanntmachung des Hinweises auf die Patenterteilung:
**13.06.2018 Patentblatt 2018/24**

(21) Anmeldenummer: **14814759.8**

(22) Anmeldetag: **24.11.2014**

(51) Int Cl.:
*C23C 28/00* *(2006.01)*    *C23C 28/04* *(2006.01)*
*C23C 14/06* *(2006.01)*    *C23C 14/32* *(2006.01)*
*C23C 14/35* *(2006.01)*    *C23C 16/34* *(2006.01)*
*B24B 37/24* *(2012.01)*    *C23C 14/08* *(2006.01)*

(86) Internationale Anmeldenummer:
**PCT/EP2014/003124**

(87) Internationale Veröffentlichungsnummer:
**WO 2015/078570 (04.06.2015 Gazette 2015/22)**

(54) **HARTSTOFFSCHICHT ZUR REDUZIERUNG EINES WÄRMEEINTRAGS IN DAS BESCHICHTETE SUBSTRAT**

HARD MATERIAL LAYER FOR REDUCING HEAT INPUT INTO A COATED SUBSTRATE

COUCHE DE SUBSTANCE DURE PERMETTANT DE RÉDUIRE UN APPORT DE CHALEUR DANS LE SUBSTRAT REVÊTU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.11.2013 DE 102013019691**

(43) Veröffentlichungstag der Anmeldung:
**05.10.2016 Patentblatt 2016/40**

(73) Patentinhaber: **Oerlikon Surface Solutions AG, Pfäffikon**
**8808 Pfäffikon (CH)**

(72) Erfinder:
- **SOBIECH, Matthias Lukas**
  **88131 Bodolz/Bettnau (DE)**
- **STEIN, Sebastian**
  **77855 Achern (DE)**
- **SHKLOVER, Valery**
  **8006 Zürich (CH)**
- **BOETTGER, Paul Heinrich Michael**
  **4020 Linz (AT)**
- **PATSCHEIDER, Joerg**
  **8706 Meilen (CH)**

(74) Vertreter: **Misselhorn, Hein-Martin**
**Patent- und Rechtsanwalt**
**Donaustrasse 6**
**85049 Ingolstadt (DE)**

(56) Entgegenhaltungen:
**EP-A1- 1 186 681**     **WO-A1-2008/119173**
**WO-A2-2009/079184**

- **LEMBKE M I ET AL: "Localised oxidation defects in TiAlN/CrN superlattice structured hard coatings grown by cathodic arc/ unbalanced magnetron deposition on various substrate materials", SURFACE AND COATINGS TECHNOLOGY, ELSEVIER, AMSTERDAM, NL, Bd. 125, Nr. 1-3, März 2000 (2000-03), Seiten 263-268, XP027328832, ISSN: 0257-8972 [gefunden am 2000-03-01]**

**Beschreibung**

Die vorliegende Erfindung bezieht sich auf ein beschichtetes Produkt, dessen Beschichtung eine Hartstoffschicht mit einer definierten mehrlagigen Schichtstruktur umfasst, so dass hierdurch ein Wärmeeintrag in das beschichtete Substrat infolge der Einwirkung von thermischen Hot Spots signifikant minimiert bzw. vermieden wird.

**Stand der Technik**

Bei tribologischen Prozessen, wie beispielsweise Umform- und Zerspanungsprozessen, entsteht Reibungswärme an der Grenzfläche zwischen Werkzeug- und Werkstückoberfläche in Folge mechanischer Deformationsenergie. Das Ausmass und die Dauer des Wärmeeintrags bestimmen die Temperaturverteilung in der Schicht und dem darunter liegenden Substrat. Die Werkzeug- und Werkstückoberflächen weisen im mikroskopischen Massstab morphologische Unregelmässigkeiten (sogenannten morphologische Spitzen) auf. Diese "morphologischen Spitzen" stellen beim Zerspanungsprozess die eigentlichen Kontaktflächen dar, an denen in Folge mechanischer Deformation Reibungswärme entsteht. Da der Zerspanungsprozess kontinuierlich abläuft, d.h. die "Spitzen" beider Oberflächen treten zeitlich wie auch räumlich verteilt wahllos miteinander in Kontakt, kann man nun den Wärmeeintrag in die Schichtoberfläche als einen an den morphologischen Spitzen lokal isolierten, räumlich wahllos verteilten und sich zeitlich schnell ändernden Prozess darstellen. Vor diesem Hintergrund ist es ersichtlich, dass ein auf den jeweiligen Zerspanungsprozess angepasstes Wärmemanagement in der Schicht zur erheblichen Leistungssteigerung des Gesamtsystems beitragen kann, v.a. bei der Zerspanung von rostfreiem Stahl sowie Ti- und Ni-Basislegierungen.

EP0714996 offenbart ein Verfahren zur Minimierung von Wärmegradienten in einem Gegenstand. Gemäß diesem Verfahren wird eine Mehrzahl von Schichten vom Typ 1 und Typ 2 auf den Gegenstand derart aufgebracht, dass die Wärmegradienten in dem Gegenstand verringert werden, indem die Typ 1 Schichten thermisch weniger leitfähig sind als die Typ 2 Schichten bei irgendeiner speziellen Temperatur, so dass die Wärmeenergie, die sich senkrecht zur Schichtoberfläche durch die Schichten zu dem darunterliegenden Gegenstand ausbreitet, durch die geringere Wärmeleitfähigkeit der Typ 1 Schichten behindert und im Wesentlichen in einer seitlichen (horizontalen) Richtung durch die höhere Wärmeleitfähigkeit der Typ 2 Schichten verteilt wird. Außerdem empfiehlt EP0714996, die Schichten derart aufzubringen, dass die volumenmäßige Verteilung von einer der beiden Schichten häufiger nahe an der Grenzfläche zum Gegenstand oder häufiger nahe an der Mehrlagenschichtoberfläche ist als an jeder anderen Stelle innerhalb des Mehrlagenschichtsystems. Eine alternative Empfehlung ist die selektive Variation der Schichtdicken vom Typ 1 und 2, um dadurch die Wärmeleitfähigkeit der Schichten zu verändern. Ferner offenbart EP0714996, dass die Wärmeleitfähigkeiten der Typ 1 Schichten nicht grösser als 2.88 Wm$^{-1}$°C$^{-1}$ und die der Typ 2 Schichten nicht geringer als 14,42 Wm$^{-1}$°C$^{-1}$ sein sollen. EP0714996 erwähnt auch, dass eine Beschichtung gemäß diesem Verfahren den Vorteil hat, dass man diese auf komplexe Oberflächengeometrien wie beispielweise Oberflächen mit scharfen Kanten aufbringen kann. Als Beispiel einer Beschichtung gemäß diesem Verfahren wird eine durch EBPVD-abgeschiedene Beschichtung mit einer Typ 1 Schicht aus Yttriumstabilisiertem Zirkoniumoxid und einer Typ 2 Schicht aus Nickelaluminid angegeben. EP0714996 lehrt weiter, dass die Reihenfolge der Typ 1 und 2 Schichten nicht alternierend sein muss, sondern für die Anwendung maßgeschneidert sein soll. Darüber hinaus ist es auch bekannt, dass durch die Verwendung von EBPVD-Prozessen Beschichtungsraten in der Größenordnung von 0,1 μm/min bis 100 μm/min üblich sind. Dennoch wird in EP0714996 kein konkreter Hinweis über die Schichtdickengrößenordnung ersichtlich, weder in Bezug auf die Gesamtschichtdicke der Mehrlagenbeschichtung noch in Bezug auf die einzelnen Schichtdicken vom Typ 1 und Typ 2.

Ein Beschichtungskonzept zum Schutz von Zerspanungswerkzeugen, die aufgrund eines durch den tribologischen Kontakt generierten Wärmeeintrags versagen, bezieht sich auf die Abscheidung von Beschichtungen mit einer im Allgemeinen geringen Wärmeleitfähigkeit. In diesem Sinne offenbart WO2013156131 eine Beschichtung zur Minimierung von Kolkverschleiß, umfassend mindestens einen Mehrschichtfilm aus abwechselnd abgeschiedenen A- und B-Nanoschichten mit geringer Wärmeleitfähigkeit und Schichtdicken kleiner 200 nm, vorzugsweise kleiner 100 nm, wobei die A-Nanoschichten im wesentlichen Aluminiumchrombornitrid und die B-Nanoschichten im wesentlichen Aluminiumchromnitrid enthalten und dadurch die Beschichtung eine sehr geringe Wärmeleitfähigkeit, nämlich unter 3,0 Wm$^{-1}$K$^{-1}$, aufweist.

Aus der WO 2009/079184 ist eine mit Nano-Schichten beschichtete Wendeschneidplatte zur spanenden Bearbeitung bekannt, bei der der Wärmeeintrag in das Substrat der Schneidplatte sowie in das Interface zwischen Substrat und Beschichtung verringert wird, und eine Methode zur Beschichtung des Substrats. Dabei liegen zwischen der untersten und der obersten Schicht alternierende Nano-Schichten mit einer Gesamtschichtdicke von 1500 - 15000 nm.

Es besteht weiterhin ein großer Bedarf, ein Beschichtungskonzept zu entwickeln, das einen Wärmeeintrag in das beschichtete Substrat, infolge der Einwirkung von thermischen Hot Spots, effektiv vermeiden kann, aber gleichzeitig für verschiedene tribologische Applikationen anwendbar ist, so dass beispielsweise im Rahmen der Zerspanungs- und Umformungstechnik die Verwendung von vielfältigen Schichtmaterialen zur Erzeugung von beliebigen Eigenschaften in Abhängigkeit von den jeweiligen Applikationen ermöglicht wird.

**Aufgabe der vorliegenden Erfindung**

Der vorliegenden Erfindung liegt die Aufgabe zugrunde, ein Beschichtungskonzept anzugeben, das in der Lage ist, die aktuellen Nachteile des Standes der Technik zu überwinden.

Insbesondere ist es eine Aufgabe der vorliegenden Erfindung, ein Beschichtungskonzept anzugeben, das die Bereitstellung einer Hartstoffschicht zur Beschichtung von Kontaktflächen von im Einsatz unter tribologischer Beanspruchung stehenden Substraten ermöglicht, wobei aufgrund eines definierten Schichtaufbaus der Hartstoffschicht ein Wärmeeintrag in das Schicht/Substrat-System, unter Einwirkung von thermischen Hot Spots an den Kontaktflächen, signifikant vermindert oder vorzugsweise vermieden wird und gleichzeitig durch die Hartstoffschicht eine verbesserte Performance der tribologisch beanspruchten Substrate erreicht wird.

Es ist eine weitere Aufgabe der vorliegenden Erfindung, ein Beschichtungskonzept anzugeben, das eine zufriedenstellende Werkzeugleistung bei der Zerspanung von rostfreiem Stahl sowie Ti- und Ni-Basislegierungen bei gleichzeitiger Minimierung des Wärmeeintrags in das Schicht/Substrat-System unter Einwirkung von thermischen Hot Spots ermöglicht.

**Beschreibung der vorliegenden Erfindung**

Erfindungsgemäß wird die voranstehende Aufgabe dadurch gelöst, dass ein beschichtetes Substrat mit einer Hartstoffschicht gemäß Anspruch 1 bereitgestellt wird.

Eine Hartstoffschicht gemäß der vorliegenden Erfindung umfasst eine mehrlagige Schicht mit einer mehrlagigen Schichtstruktur M und Schichtdicke $D_M$, umfassend A- und B-Schichten, die alternierend abgeschieden werden, wobei die A-Lagen eine Wärmeleitfähigkeit $\kappa_A$ und eine Einzelschichtdicke $D_A$ und die B-Lagen eine Wärmeleitfähigkeit $\kappa_B$ und eine Einzelschichtdicke $D_B$ aufweisen, wobei

- $\kappa_A < n \cdot \kappa_B$, und
- $n \geq 1.5$, und
- $\kappa_A \leq 10$
- $200 \text{ nm} \geq D_A \geq 25 \text{ nm}$ und $100 \text{ nm} \geq D_B \geq 25 \text{ nm}$, und
- $|D_A - D_B| \leq 0{,}15 \cdot D_A$ oder $|D_A - D_B| \leq 0{,}15 \cdot D_B$, und
- $D_M \geq 0.1 \ \mu\text{m}$

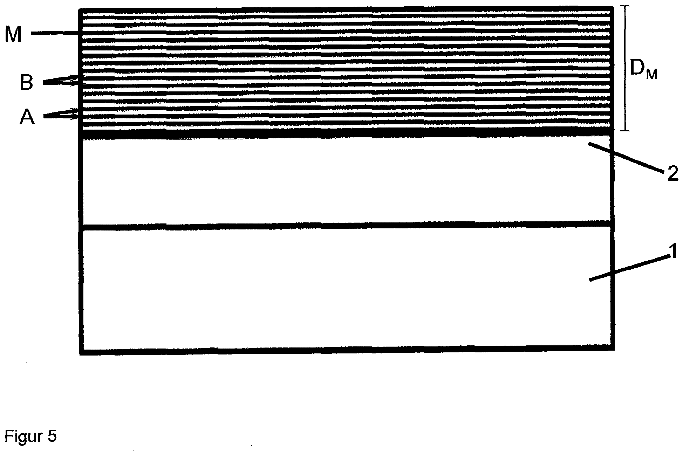

Figur 5 zeigt eine Skizze eines beschichteten Substrats gemäß der vorliegenden Erfindung, bei der die Hartstoffschicht 2 auf dem Substrat 1 abgeschieden ist, die Hartstoffschicht 2 umfasst eine mehrlagige Schicht mit einer Schichtstruktur M und eine Schichtdicke $D_M$, die aus A und B Schichten besteht. Beispielsweise, wie in der Figur 5 gezeigt, ist die mehrlagige Schicht als äußerste Schicht der Hartstoffschicht abgeschieden.

Es kann auch sein, dass die Hartstoffschicht zumindest eine Unterschicht und/oder zumindest eine Haftschicht zwischen der mehrlagigen Schicht M und dem Substrat umfasst. Es kann aber auch sein, dass die Hartstoffschicht 2 eine Deckschicht mit definierten Eigenschaften, wie z.B. eine besondere Farbe und/oder Schmierungseigenschaften, umfasst.

Vorzugsweise ist $n > 2$ und $\kappa_A \leq 6$.

Vorzugsweise ist die gesamte Schichtdicke $D_M$ (der mehrlagigen Schichtstruktur M) nicht grösser als 10 $\mu$m und nicht kleiner als 0.5 $\mu$m, noch vorzugsweiser liegt $D_M$ zwischen 1 $\mu$m und 5 $\mu$m.

In einer bevorzugten Ausführungsform einer Hartstoffschicht gemäß der vorliegenden Erfindung umfassen die A-Schichten und/oder die B-Schichten zumindest ein kubisches Übergangsmetallnitrid. Für gewisse Anwendungen kann es von Vorteil sein, dass die A-Schichten und/oder die B-Schichten aus zumindest einem kubischen Übergangsmetallnitrid bestehen.

In einer bevorzugten Ausführungsform einer Hartstoffschicht gemäß der vorliegenden Erfindung umfassen die A-Schichten und/oder die B-Schichten zumindest ein Metalloxid. Für gewisse Anwendungen kann es von Vorteil sein, dass die A-Schichten und/oder die B-Schichten aus zumindest einem Metalloxid bestehen.

Es kann auch für manche Anwendungen von Vorteil sein, dass die A-Schichten und/oder die B-Schichten sowohl ein kubisches Übergangsmetallnitrid als auch ein Metalloxid umfassen.

In einer weiteren bevorzugten Ausführungsform einer Hartstoffschicht gemäß der vorliegenden Erfindung sind die A-Schichten und/oder die B-Schichten metallische Schichten, die aus einem Metall oder aus mehreren Metallen bestehen.

Abhängig von der Defektdichte innerhalb der Schichten kann es von Vorteil sein, dass die Einzelschichtdicke der A-Schichten und B-Schichten in der Größenordnung $\leq 100$ nm oder sogar $\leq 75$ nm bleibt.

Wenn die Defektdichte eher grösser ist, sollten die Einzelschichtdicken der A-Schichten und B-Schichten auch eher grösser sein, beispielsweise in der Größenordnung $\geq 75$ nm oder sogar $\geq 100$ nm.

Ein bevorzugtes Verfahren zur Abscheidung einer Hartstoffschicht gemäß der vorliegenden Erfindung umfasst die Verwendung von PVD- und/oder CVD- und/oder PECVD-Beschichtungstechniken.

Zur Abscheidung von A-Schichten und B-Schichten in der Größenordnung $\leq$ 100 nm oder $\leq$ 75 nm sollte das Verfahren erfindungsgemäß die Verwendung von Magnetron Sputtering Techniken oder vorzugsweise HIPIMS Techniken umfassen.

Zur Abscheidung von A-Schichten und B-Schichten in der Größenordnung $\geq$ 75 nm oder sogar $\geq$ 100 nm kann es von Vorteil sein, dass das Verfahren erfindungsgemäß die Verwendung von Arc Ion Plating Techniken umfasst.

Gemäß der vorliegenden Erfindung kann diese Hartstoffschicht auf Oberflächen von Substraten aufgebracht werden, die tribologisch beansprucht werden, um einen unerwünschten massiven Wärmeeintrag in das beschichtete Substrat, durch die zwangsläufige Entstehung von thermischen Hot Spots, zu vermindern oder vorzugsweise zu vermeiden und gleichzeitig eine verbesserte Performance der tribologisch beanspruchten Substrate zu erreichen.

Vorzugsweise können erfindungsgemäß Zerspanungswerkzeuge oder Umformungswerkzeuge beschichtet werden, aber auch im Allgemeinen Bauteile, die unter tribologischen Beanspruchungen verwendet werden.

Die Hartstoffschichten gemäß der vorliegenden Erfindung haben anisotrope Eigenschaften in Bezug auf Wärmeleitfähigkeit, um effektiv in der Lage zu sein, die z.B. beim Zerspanen eingebrachte Wärme gleichmäßig zu "verteilen" und sogar an den Span abzugeben und somit die lokalen Temperaturmaxima im Schicht/Substrat-System signifikant zu reduzieren.

Im Folgenden wird der positive Einfluss von Hartstoffschichtsystemen mit ausgeprägter, anisotroper Wärmeleitfähigkeit beispielhaft für den Zerspanungsprozess dargestellt:

Hartstoffschichtsysteme mit ausgeprägter, anisotroper Wärmeleitfähigkeit (in-plane $\kappa_{\parallel}$ grösser als out-of-plane $\kappa_{\perp}$) haben einen grossen (positiven) Einfluss auf die Temperaturverteilung im Schicht/Substrat-System beim Zerspanungsprozess unter Annahme der oben beschriebenen Hot Spot Kontaktflächensituation. Die anisotrope Wärmeleitfähigkeit in der Schicht erniedrigt die Ausprägung von thermischen Gradienten an der Grenzfläche zwischen Schicht und Substrat und reduziert dadurch erheblich den Wärmeeintrag in das Substrat (Werkzeug) während dem Zerspanungsprozess.

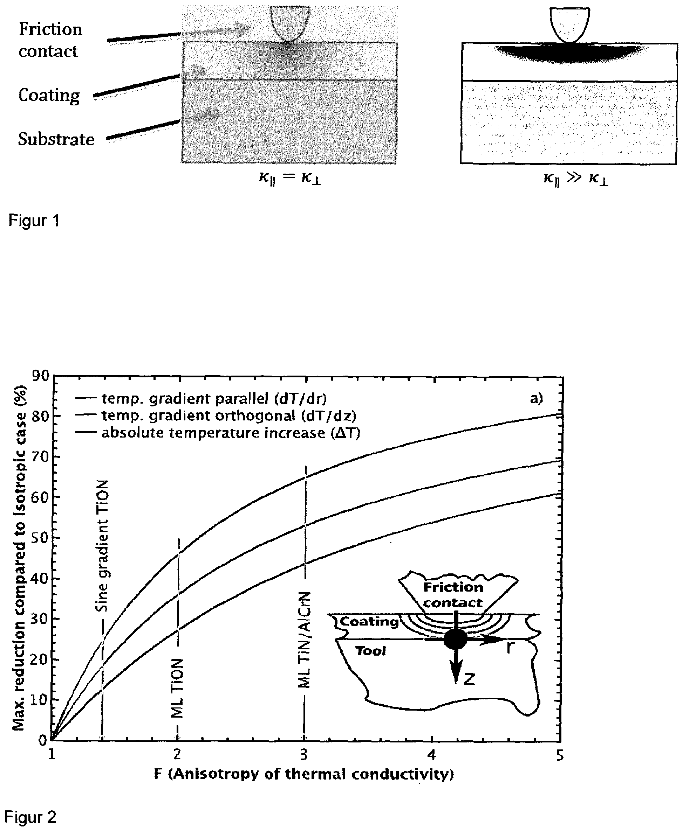

In der Fig. 1 ist die laterale Temperaturverteilung in der Schicht dargestellt unter Annahme eines tribologischen Reibkontakts, links für isotrope und rechts für anisotrope Hartstoffschichten in Bezug auf Wärmeleitfähigkeit.

Eine sehr effektive Möglichkeit, um in dünnen Hartstoffschichten anisotrope Wärmeleitfähigkeit zu erzeugen, beruht auf dem Prinzip des Mehrlagenschichtsystems, d.h. Abscheidung von unterschiedlichen Hartstoffschichten im regelmässigen Wechsel übereinander. Bedingt durch das "übereinander Stapeln" von Hartstoffschichten mit unterschiedlicher Wärmeleitfähigkeit resultiert durch den thermischen Widerstand an der internen Subschichtgrenzfläche eine anisotrope Wärmeleitfähigkeit, die parallel zur Schichtoberfläche grösser ist als senkrecht zur Schichtoberfläche.

Mathematisch kann dieser Zusammenhang wie folgt ausgedrückt werden (Anzahl der Subschichten i mit der jeweiligen Wärmeleitfähigkeit $\kappa_i$, und dem Volumenanteil $f_i$, in-plane Wärmeleitfähigkeit $\kappa_{\parallel}$ und out-of-plane Wärmeleitfähigkeit $\kappa_{\perp}$):

$$\kappa_{\parallel} = \sum_{i} f_i \kappa_i$$

$$\frac{1}{\kappa_{\perp}} = \sum_{i} \frac{f_i}{\kappa_i}$$

Für ein Mehrlagenschichtsystem bestehend aus 2 unterschiedlichen Hartstoffschichten (mit 2 unterschiedlichen Wärmeleitfähigkeiten $\kappa_1$ und $\kappa_2$) ergibt sich die höchste Anisotropie $F = \kappa_{\parallel}/\kappa_{\perp}$ für einen gleichen Volumenanteil von $f_1 = f_2 = 0.5$ entsprechend (ohne Berücksichtigung des Einflusses vom thermischen Grenzflächenwiderstand und unter Annahme einer "perfekten, atomar glatten" Grenzfläche):

$$F_{bilayer} \equiv \frac{\kappa_{\parallel}}{\kappa_{\perp}} = \frac{\left(1+\frac{\kappa_1}{\kappa_2}\right)^2}{4\frac{\kappa_1}{\kappa_2}}$$

Die allgemeine Wärmegleichung in zylindrischer Symmetrie ist wie folgt gegeben:

$$\frac{\partial T}{\partial t} = -\kappa_{\parallel} \frac{1}{\rho} \frac{\partial}{\partial \rho} \left( \rho \frac{\partial T}{\partial \rho} \right) - \kappa_{\perp} \frac{\partial^2 T}{\partial z^2} = Q(\rho, z) \delta(t)$$

Unter Berücksichtigung dieser allgemeinen Wärmegleichung für ein Hartstoffschichtsystem mit anisotroper Wärmeleitfähigkeit kann nun folgender, allgemein gültiger Zusammenhang zwischen Anisotropie der Wärmeleitfähigkeit und der Temperaturerniedrigung im Schicht/Substrat-System für den Fall der dargestellten Hot Spot Kontaktflächensituation aufgestellt werden (siehe Fig. 2). Die laterale Ausdehnung des Hot Spot ist doppelt so gross wie die Schichtdicke.

Somit folgt, dass mit zunehmender Anisotropie in der Wärmeleitfähigkeit die absolute Schichttemperatur sowie die maximale Ausprägung der Wärmegradienten parallel und senkrecht zur Grenzfläche Schicht/Substrat signifikant erniedrigt werden im Vergleich zu isotropen Schichten gleicher Schichtdicke, jedoch ohne Mehrlagenstruktur.

Ein Beispiel hierzu stellt das Mehrlagenschichtsystem TiN/AlCrN (ML TiN/AlCrN) dar: Eine regelmässige Wechselfolge von TiN ($\kappa$ = 30 Wm$^{-1}$K$^{-1}$) und AlCrN ($\kappa$ = 3 Wm$^{-1}$K$^{-1}$) bei einer Gesamtschichtdicke vom 5 $\mu$m ergibt einen Anisotropiewert von F = 3. Hierdurch kann die maximale Schichttemperatur an der Schicht/Substrat-Grenzfläche um 50% reduziert werden, unter der Voraussetzung, dass die Kontaktflächensituation wie oben beschriebenen Hot Spot Charakter hat.

Der oben dargestellte Zusammenhang unterliegt den folgenden Voraussetzungen:

- Genaue Kenntnis der Wärmeleitfähigkeitseigenschaften der einzelnen Subschichten (d.h. Anwendung entsprechender experimenteller Methoden/Vorgehensweisen),
- gezielte Kontrolle der Wärmeleitfähigkeitseigenschaften der einzelnen Subschichten mittels Kontrolle mikrostruktureller Eigenschaften (chemische und strukturelle Zusammensetzung, Korngrösse, Defektdichte, kristallographische Textur), und
- gezielte Anwendung angepasster/optimierter PVD Verfahren zur Hartstoffschichtherstellung mit gewünschten Eigenschaften, v.a. im Hinblick auf "Reinheit und Schärfe" der Grenzflächen der einzelnen Subschichten im Mehrlagenschichtsystem.

In Rahmen der vorliegenden Erfindung haben die Erfinder festgestellt, dass erstaunlicherweise die Einzelschichtdicken der A- und B-Schichten in der mehrlagigen Schichtstruktur mindestens 25 nm betragen müssen, bzw. vorzugsweise in einer Grössenordnung grösser 25 nm liegen müssen, um die erforderliche anisotrope Wärmeleitfähigkeit zu realisieren. Es ist aber auch von Vorteil, dass so viele Grenzflächen wie möglich in der mehrlagigen Schichtstruktur erzeugt werden, um den Wärmeeintrag in der mehrlagigen Schichtstruktur optimal verteilen zu können.

Strategie zur Realisierung von Hartstoffschichten mit anisotroper Wärmeleitfähigkeit gemäss der vorliegenden Erfindung:

Im Folgenden wird eine Art "Rezept" (Strategie) beschrieben, wie man vorzugehen hat, wenn Hartstoffschichten mit anisotroper Wärmeleitfähigkeit erzeugt werden sollen, unter der Voraussetzung, dass die jeweiligen Subschichtendicken einen freien, variablen Parameter darstellen, so lange die Volumenanteile beider Subschichten gleich sind:

Materialauswahl: Grundsätzlich sollen die beiden Materialien der Subschichten möglichst unterschiedliche Wärmeleitfähigkeiten aufweisen. Gleichzeitig ist es jedoch auch wichtig, dass die beiden Materialien der Subschichten möglichst "kompatibel" sind in Bezug auf i) kristallographische Struktur, ii) thermische Ausdehnung, iii) thermische Stabilität und iv) mechanische Performance (Härte, E-Modul). Kubische Übergangsmetallnitride (wie z.B. CrN, TiN, TiAlN, AlCrN, etc.) sowie deren Carbo- und Oxynitride (wie z.B. CrCN, TiCN, TiAlCN, AlCrCN, CrON, TiON, TiAlON, AlCrON, etc.) sind in einem sehr weiten Bereich kombinierbar und somit nicht nur von der Anwendungsseite her bestens geeignet. Um für den speziellen Anwendungsfall die Eigenschaften der Schichten im Hinblick auf strukturelle, chemische und mechanische Performance zu optimieren, sollen Legierungselemente eingesetzt werden: Si, B, V, Ta, W, Nb, Y, Mo, Ni, Zr. Aber auch rein oxydische sowie metallische/intermetallische Schichten sind geeignet für den Einsatz im Mehrlagenschichtsystem auf Grund ihrer sehr variablen Wärmeleitfähigkeit.

Subschichtendicke: Grundsätzlich müssen die einzelnen Subschichten eine ausreichende Dicke haben, um Wärmeleitfähigkeit wie in einem Bulk-Material aufzuweisen, d.h. die einzelnen Subschichten müssen deutlich dicker sein als die durchschnittliche freie Weglänge von (wärmetransportierenden) Phononen (Gitterschwingungen), woraus sich für reale (industrielle) Hartstoffschichten (unabhängig von der Herstellungsmethode) intrinsisch eine untere Grenze von 25 nm ergibt. Die eigentliche Subschichtdicke hängt wiederum von weiteren Faktoren (Grenzflächenmorphologie, thermischer Grenzflächenwiderstand, Grenzflächenspannungszustand und Herstellungsmethode) ab, die im Folgenden beschrieben sind:

Grenzflächenmorphologie: Die reale "Rauigkeit" (Parallelität & Welligkeit) sowie die reale "Schärfe" (chemische & strukturelle Übergänge) der Grenzflächen zwischen den einzelnen Subschichten haben einen direkten Einfluss auf die untere Grenze der Subschichtdicken (siehe Punkt oben), d.h. die Grenzflächenmorphologie (Rauigkeit und Schärfe) entscheidet über die untere Grenze der Subschichtdicken, damit in den einzelnen Subschichten ungestört "Bulk-Wärmeleitfähigkeit" vorliegt. Dieser Sachverhalt steht im direkten Zusammenhang mit der gewählten Schichtherstellungsmethode, d.h. je "sauberer" und "reiner" die Herstellungsmethode, umso geringer können die Subschichtdicken gewählt werden.

Thermischer Grenzflächenwiderstand: An jeder Grenzfläche wird die Wärmeleitung senkrecht zur Schicht erniedrigt, wobei die Wärmeleitung parallel zur Schicht unbeeinflusst bleibt. Aus diesem Grund ist es sinnvoll, die Anzahl der Subschichten (und somit die Anzahl an Grenzflächen) für eine gewählte Gesamtschichtdicke zu erhöhen, d.h. die Subschichtdicken zu erniedrigen.

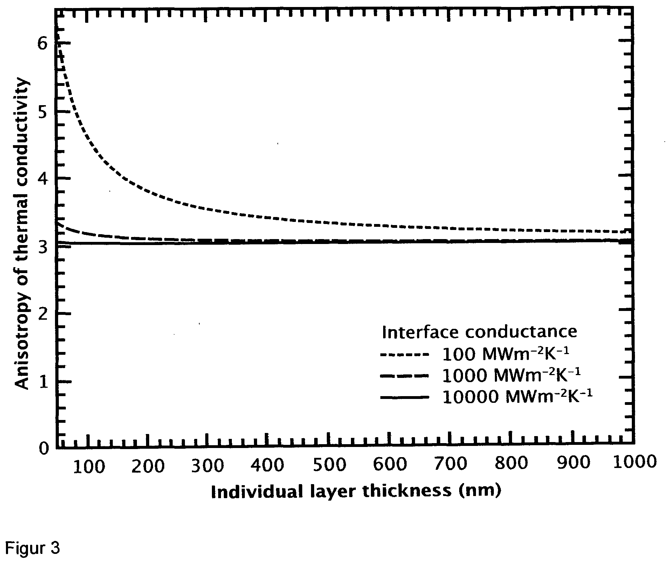

Die Fig. 3 veranschaulicht den Zusammenhang zwischen anisotroper Wärmeleitung und der individuellen Subschichtdicke für verschiedene thermische Grenzflächen-Widerstände bei einer Gesamtschichtdicke von 5 $\mu$m.

Grenzflächenspannungszustand: Um die thermisch induzierten, mechanischen Spannungen an den Grenzflächen zu reduzieren, sollten die Subschichtdicken ebenfalls möglichst gering sein.

Herstellungsmethode: Mit Hilfe der Herstellungsmethode kann in erster Linie die Grenzflächenmorphologie (siehe Punkt oben) kontrolliert werden, d.h. die gezielte Auswahl einer Herstellungsmethode ermöglicht eine gezielte Kontrolle der Grenzflächenrauigkeit sowie der Grenzflächenschärfe, was wiederum eine gezielte Variation der Subschichtdicke ermöglicht.

Konkretes Beispiel einer Hartstoffschicht gemäss der vorliegenden Erfindung:

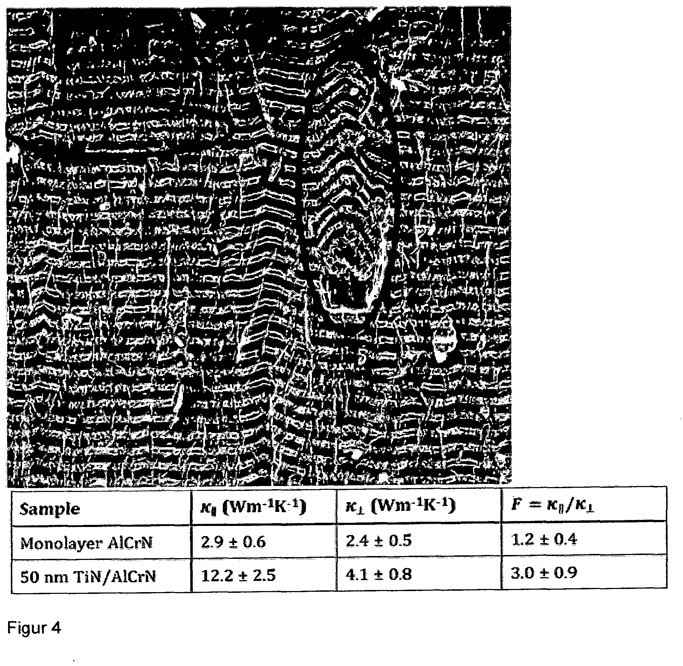

Es wurde eine Hartstoffschicht mit einer Gesamtschichtdicke von 5 $\mu$m mittels Arc PVD hergestellt. Diese Schicht stellt eine regelmässige Wechselfolge von TiN ($\kappa$ = 30 Wm-1K-1) und AlCrN ($\kappa$ = 3 Wm-1K-1) dar und weist einen theoretischen Anisotropiewert von 3 auf. Um diesen theoretischen Wert experimentell zu bestätigen, wurde eine spezielle Vorgehensweise entwickelt, indem sehr dicke Schichten von 15-20 $\mu$m Gesamtdicke hergestellt (siehe Fig.4) und anschliessend an einem Querschliff mittels der etablierten Methode "time-domain thermoreflectance" (D. G. Cahill, Rev. Sci. Inst. 75 (2004) 5119-5122) parallel wie auch senkrecht zur Schicht vermessen wurden. Auf diese Art und Weise war es erstmals möglich, die Anisotropie in der Wärmeleitfähigkeit einer dünnen Hartstoffschicht direkt experimentell zu bestimmen.

Wie in der Fig. 4 (Helium-Ionen-Mikroskopie Aufnahme) zu sehen, enthalten Arc PVD Schichten Unregelmässigkeiten wie Abweichungen der Einzelschichtdicken der A- und B-Schichten (auch im Rahmen der vorliegenden Erfindung Subschichtdicken genannt) und Morphologiestörungen durch das Überwachsen eines Droplets. Trotz dieser "Defekte" konnte für dieses Schichtsystem experimentell ein Anisotropiewert von F = 3 gemessen werden (so, wie es theoretisch vorhergesagt wurde), im Vergleich zu einem Anisotropiewert von F =1 für reines AlCrN ohne Mehrlagenstruktur (siehe Tabelle unter der Grafik in der Fig. 4), d.h. reines AlCrN ohne Mehrlagenstruktur ist isotrop im Hinblick auf die Wärmeleitfähigkeit, wie es auch zu erwarten war.

**Patentansprüche**

1. Mit einer Hartstoffschicht (2) beschichtetes Substrat, die auf zumindest einem Teil einer Oberfläche eines Substrats (1) abgeschieden ist, wobei die Hartstoffschicht (2) eine mehrlagige Schicht mit mehrlagiger Schichtstruktur M und Schichtdicke $D_M$ umfasst, umfassend A- und B-Lagen alternierend mit unterschiedlicher Wärmeleitfähigkeit abgeschieden, wobei die A-Lagen eine Wärmeleitfähigkeit $_{KA}$ in Wm-1K-1 und eine Einzelschichtdicke $D_A$ und die B-Lagen eine Wärmeleitfähigkeit $_{KB}$ und eine Einzelschichtdicke $D_B$ aufweisen, **dadurch gekennzeichnet, dass**

   - $_{KA}$ < n·$_{KB}$, und
   - n $\geq$ 1.5, und
   - $_{KA}$ $\leq$ 10
   - 200 nm $\geq$ D$_A$ $\geq$ 25 nm und 100 nm $\geq$ D$_B$ $\geq$ 25 nm, und
   - |D$_A$- D$_B$| $\leq$ 0.15.D$_A$ oder |D$_A$- D$_B$| $\leq$ 0.15·D$_B$, und
   - D$_M$ $\geq$ 0.1 $\mu$m,

   und dass die beiden Materialien der Subschichten, d. h. der A-Lagen und B-Lagen der mehrlagigen Schicht zumindest ein kubisches Übergangsmetallnitrid umfassen oder aus kubischen Übergangsmetallnitriden, wie z.B. CrN, TiN, TiAlN, AlCrN, oder deren Carbo- oder Oxynitriden, wie z.B. CrCN, TiCN, TiAlCN, AlCrCN, CrON, TiON, TiAlON, AlCrON ausgewählt sind, wobei wahlweise Legierungselemente wie Si, B, V, Ta, W, Nb, Y, Mo, Ni, Zr eingesetzt werden können, oder die Subschichten aus rein oxydischen, oder metallischen/intermetallischen Schichten ausgewählt sind.

2. Beschichtetes Substrat gemäß Anspruch 1, **dadurch gekennzeichnet, dass** n > 2 und $\kappa_A$ $\leq$ 6.

3. Beschichtetes Substrat gemäß zumindest einem der vorhergehenden Ansprüche 1 oder 2, **dadurch gekennzeichnet, dass** 10 $\mu$m $\geq$ D$_M$ $\geq$ 0.5 $\mu$m, vorzugsweise 5 $\mu$m $\geq$ D$_M$ $\geq$ $\mu$m.

**4.** Beschichtetes Substrat gemäß zumindest einem der vorhergehenden Ansprüche 1 bis 3, **dadurch gekennzeichnet, dass** die A-Lagen und/oder die B-Lagen zumindest ein kubisches Übergangsmetallnitrid umfassen, vorzugsweise aus zumindest einem kubischen Übergangsmetallnitrid bestehen.

**5.** Beschichtetes Substrat gemäß zumindest einem der vorhergehenden Ansprüche 1 bis 3, **dadurch gekennzeichnet, dass** die A-Lagen und/oder die B-Lagen zumindest ein Metalloxid umfassen, vorzugsweise aus zumindest einem Metalloxid bestehen.

**6.** Beschichtetes Substrat gemäß zumindest einem der vorhergehenden Ansprüche 1 bis 5, **dadurch gekennzeichnet, dass** die A- oder die B-Lagen zumindest aus einem kubischen Übergangsmetallnitrid bestehen, oder die A- oder die B-Lagen aus zumindest einem Metalloxid bestehen.

**7.** Beschichtetes Substrat gemäß einem der vorhergehenden Ansprüche 1 bis 6, **dadurch gekennzeichnet, dass** die A-Lagen oder die B-Lagen metallische Schichten sind, die aus einem Metall oder aus mehreren Metallen bestehen.

**8.** Beschichtetes Substrat gemäß einem der vorhergehenden Ansprüche 1 bis 7, **dadurch gekennzeichnet, dass** die Einzelschichtdicke der A-Lagen und B-Lagen $\leq 100$ nm, vorzugsweise $\leq 75$ nm ist.

**9.** Beschichtetes Substrat gemäß zumindest einem der vorhergehenden Ansprüche 1 bis 7, **dadurch gekennzeichnet**, die Einzelschichtdicke der A-Lagen und B-Lagen $\geq 75$ nm, vorzugsweise $\geq 100$ nm ist.

**10.** Beschichtetes Substrat gemäß zumindest einem der vorgehenden Ansprüche 1 bis 9, **dadurch gekennzeichnet, dass** das Substrat ein Bauteil oder ein Werkzeug ist, dessen beschichtete Oberfläche tribologischen Beanspruchungen unterzogen wird, vorzugsweise ist das Substrat ein Zerspanungswerkzeug oder ein Umformungswerkzeug.

**11.** Verfahren zur Abscheidung einer Hartstoffschicht gemäß zumindest einem der vorhergehenden Ansprüche 1 bis 9 unter Verwendung von PVD- und/oder CVD- und/oder PECVD-Beschichtungstechniken.

**12.** Verfahren zur Abscheidung einer Hartstoffschicht gemäß Anspruch 8, **dadurch gekennzeichnet, dass** zumindest die A-Lagen und/oder die B-Lagen mittels Magnetron Sputtering Techniken abgeschieden werden, vorzugsweise mittels HIPIMS Techniken.

**13.** Verfahren zur Abscheidung einer Hartstoffschicht gemäß Anspruch 9, **dadurch gekennzeichnet, dass** zumindest die A-Lagen und/oder die B-Lagen mittels Arc Ion Plating Techniken abgeschieden werden.

**Claims**

**1.** A substrate coated with a hard material layer (2), which is deposited on at least a part of the surface of a substrate (1); the hard material layer (2) comprises a multilayer coating with a multilayer coating structure M and coating thickness $D_M$, comprising A layers and B layers with different thermal conductivity in alternation, the A layers having a thermal conductivity $_{KA}$ in $Wm^{-1}K^{-1}$ and an individual layer thickness $D_A$ and the B layers having a thermal conductivity $_{KB}$ and an individual layer thickness $D_B$, **characterized in that**

- $_{KA} < n \cdot {}_{KB}$ and
- $n \geq 1.5$ and
- $_{KA} \leq 10$
- $200$ nm $\geq D_A \geq 25$ nm and $100$ nm $\geq D_B \geq 25$ nm and
- $|D_A - D_B| \leq 0.15 \, D_A$ or $|D_A - D_B| \leq 0.15 \cdot D_B$, and
- $D_M \geq 0.1 \, \mu m$,

and the two materials of the sublayers, i.e. the A layers and B layers of the multilayer coating, comprise at least one cubic transition metal nitride or are selected from cubic transition metal nitrides such as CrN, TiN, TiAlN, AlCrN, or their carbonitrides or oxynitrides, e.g. CrCn, TiCN, TiAlCN, AlCrN, CrON, TiON, TiAlON, AlCrON, where alloying elements such as Si, B, V, Ta, W, Nb, Y, Mo, Ni, Zr can optionally be used or the sublayers can be composed of purely oxide layers or metallic/intermetallic layers.

**2.** The coated substrate according to claim 1, **characterized in that** $n > 2$ and $_{KA} \leq 6$.

3. The coated substrate according to at least one of the preceding claims 1 or 2, **characterized in that** 10 $\mu$m $\geq$ D$_M$ $\geq$ 0.5 $\mu$m, preferably 5 $\mu$m $\geq$ D$_M$ $\geq$ 1 $\mu$m.

4. The coated substrate according to at least one of the preceding claims 1 through 3, **characterized in that** the A layers and/or the B layers comprise at least one cubic transition metal nitride and preferably consist of at least one cubic transition metal nitride.

5. The coated substrate according to at least one of the preceding claims 1 through 3, **characterized in that** the A layers and/or the B layers comprise at least one metal oxide and preferably consist of at least one metal oxide.

6. The coated substrate according to at least one of the preceding claims 1 through 5, **characterized in that** the A layers or the B layers consist of at least one cubic transition metal nitride or the A layers or the B layers consist of at least one metal oxide.

7. The coated substrate according to one of the preceding claims 1 through 6, **characterized in that** the A layers or the B layers are metallic layers that consist of one metal or of a plurality of metals.

8. The coated substrate according to one of the preceding claims 1 through 7, **characterized in that** the individual layer thickness of the A layers and B layers is $\leq$ 100 nm, preferably $\leq$ 75 nm.

9. The coated substrate according to at least one of the preceding claims 1 through 7, **characterized in that** the individual layer thickness of the A layers and B layers is $\geq$ 75 nm, preferably $\geq$ 100 nm.

10. The coated substrate according to at least one of the preceding claims 1 through 9, **characterized in that** the substrate is a component or a tool whose coated surface is subjected to tribological stresses, preferably a material-removing machining tool or a shaping tool.

11. A method for depositing a hard material coating according to at least one of the preceding claims 1 through 9 using PVD and/or CVD and/or PECVD coating techniques.

12. The method for depositing a hard material coating according to claim 8, **characterized in that** at least the A layers and/or the B layers are deposited by means of magnetron sputtering techniques, preferably by means of HIPIMS techniques.

13. The method for depositing a hard material coating according to claim 9, **characterized in that** at least the A layers and/or the B layers are deposited by means of arc ion plating techniques.

**Revendications**

1. Substrat revêtu d'une couche de substance dure (2) déposée sur une partie au moins d'une surface d'un substrat (1), la couche de substance dure (2) comprenant une couche multi-nappe ayant une structure de couche multi-nappe M et une épaisseur de couche D$_M$, comprenant en alternance des nappes A et B de différentes conductivités thermiques, les nappes A ayant une conductivité thermique $_{KA}$ en Wm$^{-1}$K$^{-1}$ et une épaisseur de couche individuelle D$_A$ et les nappes B ayant une conductivité thermique $_{KB}$ et une épaisseur de couche individuelle D$_B$, **caractérisé en ce que**

- $_{KB}$ < n • $_{KB}$, et
- n $\geq$ 1.5, et
- $_{KA}$ $\leq$ 10
- 200 nm $\geq$ D$_A$ $\geq$ 25 nm et 100 nm $\geq$ D$_B$ $\geq$ 25 nm, et
- |D$_A$ - D$_B$| $\leq$ 0.15 • D$_A$ ou |D$_A$-D$_B$| $\leq$ 0.15 • D$_B$, et
- D$_M$ $\geq$ 0.1 $\mu$m,

et **en ce que** les deux matériaux des sous-couches, soit les nappes A et les nappes B de la couche multi-nappe, comprennent au moins un nitrure de métal de transition cubique ou sont choisis parmi les nitrures de métal de transition, comme par exemple CrN, TiN, TiAlN, ALCrN, ou leurs carbonitrures ou oxynitrures, comme par exemple CrCN, TiCN, TiAlCN, ALCrCN, CrON, TiON, TiALON, AlCrOn, en pouvant utiliser au choix des éléments d'alliage tels que Si, B, V, Ta, W, Nb, Y, Mo, Ni, Zr, ou les sous-couches sont choisies parmi les couches purement oxydiques ou métalliques/intermétalliques.

2. Substrat revêtu selon la revendication 1, **caractérisé en ce que** n > 2 et $_{KA} \leq 6$.

3. Substrat revêtu selon l'une au moins des revendications précédentes 1 ou 2, **caractérisé en ce que** 10 $\mu$m $\geq D_M$ $\geq 0.5$ $\mu$m, de préférence 5 $\mu$m $\geq D_M \geq 1$ $\mu$m.

4. Substrat revêtu selon l'une au moins des revendications précédentes 1 à 3, **caractérisé en ce que** les nappes A et/ou les nappes B comprennent au moins un nitrure de métal de transition cubique, et sont de préférence constituées d'au moins un nitrure de métal de transition cubique.

5. Substrat revêtu selon l'une au moins des revendications précédentes 1 à 3, **caractérisé en ce que** les nappes A et/ou les nappes B comprennent au moins un oxyde métallique, et sont de préférence constituées d'au moins un oxyde métallique.

6. Substrat revêtu selon l'une au moins des revendications précédentes 1 à 5, **caractérisé en ce que** les nappes A ou les nappes B sont constituées d'au moins un nitrure de métal de transition cubique, ou les nappes A ou B sont constituées d'au moins un oxyde métallique.

7. Substrat revêtu selon l'une au moins des revendications précédentes 1 à 6, **caractérisé en ce que** les nappes A ou les nappes B sont des couches métalliques qui sont constituées d'un métal ou de plusieurs métaux.

8. Substrat revêtu selon l'une au moins des revendications précédentes 1 à 7, **caractérisé en ce que** l'épaisseur de couche individuelle des nappes A et des nappes B est $\leq$ 100 nm, de préférence $\leq$ 75 nm.

9. Substrat revêtu selon l'une au moins des revendications précédentes 1 à 7, **caractérisé en ce que** l'épaisseur de couche individuelle des nappes A et des nappes B est $\geq$ 75 nm, de préférence $\geq$ 100 nm.

10. Substrat revêtu selon l'une au moins des revendications précédentes 1 à 9, **caractérisé en ce que** le substrat est un composant ou un outil dont la surface revêtue est soumise à des contraintes tribologiques, de préférence le substrat est un outil d'usinage ou un outil de mise en forme.

11. Procédé de dépôt d'une couche de substance dure selon l'une au moins des revendications précédentes 1 à 9 en utilisant des techniques de revêtement PVD et/ou CVD et/ou PECVD.

12. Procédé de dépôt d'une couche de substance dure selon la revendication 8, **caractérisé en ce que** au moins les nappes A et/ou les nappes B sont déposées par des techniques de pulvérisation par magnétron, de préférence par des techniques HIPIMS.

13. Procédé de dépôt d'une couche de substance dure selon la revendication 9, **caractérisé en ce que** au moins les nappes A et/ou les nappes B sont déposées par des techniques de placage ionique à l'arc.

Figur 1

Figur 2

Figur 3

| Sample | $\kappa_{\parallel}$ (Wm$^{-1}$K$^{-1}$) | $\kappa_{\perp}$ (Wm$^{-1}$K$^{-1}$) | $F = \kappa_{\parallel}/\kappa_{\perp}$ |
|---|---|---|---|
| Monolayer AlCrN | 2.9 ± 0.6 | 2.4 ± 0.5 | 1.2 ± 0.4 |
| 50 nm TiN/AlCrN | 12.2 ± 2.5 | 4.1 ± 0.8 | 3.0 ± 0.9 |

Figur 4

Figur 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0714996 A
- WO 2013156131 A
- WO 2009079184 A

**In der Beschreibung aufgeführte Nicht-Patentliteratur**

- **D. G. CAHILL.** *Rev. Sci. Inst.,* 2004, vol. 75, 5119-5122